(19) Europäisches Patentamt
European Patent Office
Office européen des brevets

(11) **EP 1 635 469 A2**

(12) **EUROPEAN PATENT APPLICATION**

(43) Date of publication:
**15.03.2006 Bulletin 2006/11**

(51) Int Cl.:
***H03M 1/10*** (2006.01)

(21) Application number: **05019242.6**

(22) Date of filing: **05.09.2005**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU** | (72) Inventors:<br>• **Shiro, Dosho**<br>  **Ikeda-shi**<br>  **Osaka 563-0024 (JP)**<br>• **Takashi, Morie**<br>  **Ikeda-shi**<br>  **Osaka 567-0851 (JP)** |
| (30) Priority: **08.09.2004 JP 2004260504** | (74) Representative: **Grünecker, Kinkeldey,**<br>**Stockmair & Schwanhäusser**<br>**Anwaltssozietät**<br>**Maximilianstrasse 58**<br>**80538 München (DE)** |
| (71) Applicant: **MATSUSHITA ELECTRIC INDUSTRIAL CO., LTD.**<br>**Kadoma-shi, Osaka 571-8501 (JP)** | |

(54) **Pipelined a/d converter and method for correcting output of the same**

(57) Analog inputs to a controllable stage can be switched by an input selecting section, while digital inputs to a D/A converter in the controllable stage can also be switched. An error calculation section calculates an error in the output of the pipelined A/D converter caused by an error in the analog output of the controllable stage, based on the output of the pipelined A/D converter pro-
duced when the controllable stage is in a given input state, and an expected value thereof. A correction value generation section generates a correction value for correcting the output of the pipelined A/D converter, based on the calculated error. An output correction section corrects the output of a digital calculation section based on the generated correction value.

FIG. 7
PRIOR ART

EP 1 635 469 A2

**Description**

**CROSS-REFERENCE TO RELATED APPLICATION**

This application is related to Japanese Patent Application No. 2004-260504 filed on September 8, 2004, whose priority is claimed under 35 USC §119, the disclosure of which is incorporated herein by reference in its entirety.

**BACKGROUND OF THE INVENTION**

The present invention relates to a pipelined A/D converter, and more particularly relates to a technology of correcting the output of a pipelined A/D converter.

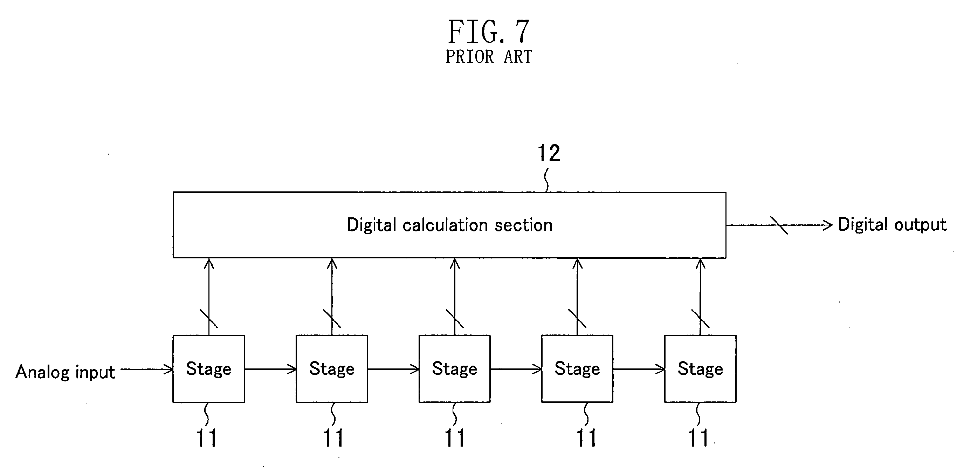

FIG. **7** illustrates the configuration of a conventional pipelined A/D converter. A pipelined A/D converter typically includes a plurality of cascade-connected stages **11** and a digital calculation section **12.** Each stage **11** converts an input analog signal to digital form and outputs the resultant digital signal to the digital calculation section **12,** while outputting to the successive stage **11** an analog signal, which is obtained by subtracting an analog value corresponding to the digital signal from the input analog signal and then doubling the resultant value. The digital calculation section **12** shifts each of the digital signals received from the respective stages **11** by one bit and adds the resultant digital values together, thereby generating the digital output of the pipelined A/D converter.

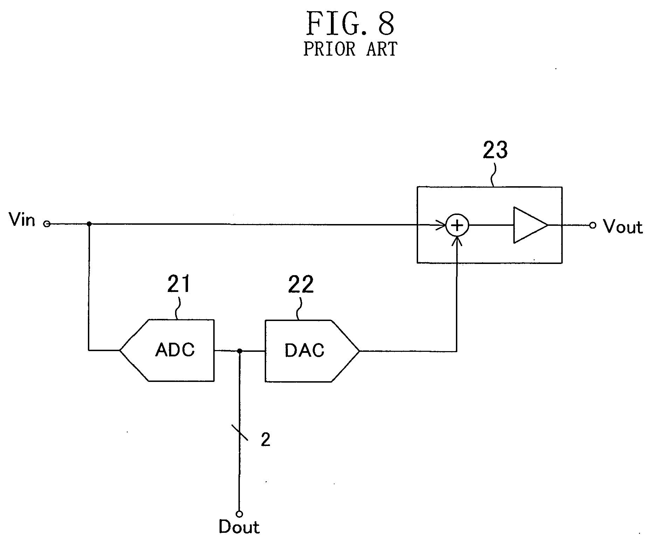

As the stages **11,** so-called 1.5-bit stages are typically used (see, for example, a doctoral dissertation by Shingo Hatanaka, "Study of the design of low-voltage, high-precision pipelined A/D converter" (Osaka University, 2002)). FIG **8** illustrates the circuit configuration of a conventional 1.5-bit stage. An A/D converter **21** converts an analog signal **Vin** to digital form, thereby generating a digital signal **Dout.** A D/A converter **22** converts the digital signal **Dout** to analog form. A summing amplifier circuit **23** adds the analog signal **Vin** and the analog output of the D/A converter **22** together and doubles the resultant value for amplification, so as to output an analog signal **Vout**.

The analog input/output characteristics of the 1.5-bit stage are expressed as the following function.

$$
Vout = \begin{cases} 2Vin + Vref & \left(-Vref \;\leqq\; Vin \;\leqq\; -\dfrac{Vref}{4}\right) \\[2mm] 2Vin & \left(-\dfrac{Vref}{4} \;\leqq\; Vin \;\leqq\; \dfrac{Vref}{4}\right) \\[2mm] 2Vin - Vref & \left(\dfrac{Vref}{4} \;\leqq\; Vin \;\leqq\; Vref\right) \end{cases}
$$

where Vref is the maximum amplitude of the analog signal **Vin.**

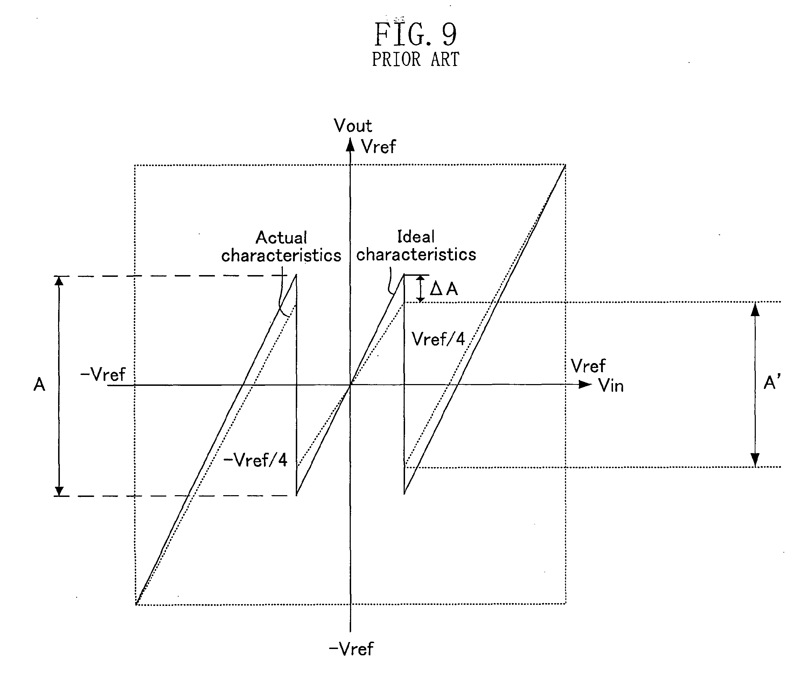

FIG **9** is a graph indicating the analog input/output characteristics of the 1.5-bit stage. The horizontal axis represents the level of the input analog signal, while the vertical axis indicates the level of the output analog signal. When -Vref ≤ Vin ≤ -Vref/4, the digital output of the 1.5-bit stage is "0b00"; when -Vref/.4 ≤ Vin ≤ Vref/4, the digital output thereof is "0b01"; and when Vref/4 ≤ Vin ≤ Vref, the digital output thereof is "0b10".

The actual analog input/output characteristics, however, deviate from the ideal characteristics to some extent due to an error in the gain of the summing amplifier circuit **23** in the 1.5-bit stage. FIG. **9** indicates the analog input/output characteristics obtained when the gain of the summing amplifier circuit **23** is smaller than "2". The discontinuity width in the nonlinear portions (i.e., the portions in which Vin = ±Vref/4) in the above function is ideally A (which is equal to Vref corresponding to one bit), but the actual discontinuity width is A'. That is, an error of ΔA(=A - A') occurs in the nonlinear portions.

The gain error and the discontinuity width error cause the pipelined A/D converter to have INL (integral non-linearity) and DNL (differential non-linearity). Specifically, INL, which is a global error in the pipelined A/D converter, occurs due mainly to an error in the gain of each stage. On the other hand, DNL, a local error in the pipelined A/D converter, is caused mainly by an error in the discontinuity width in the analog input/output characteristics of each stage. When the discontinuity width in a stage is not equal to one bit, a code error occurs, because the subtraction or addition of Vref, which is an analog value corresponding to one bit, cannot be performed in that stage. Specifically, when the discontinuity width is smaller than one bit, a missing code, a specific code that is not output, arises as an output error of the pipelined A/D converter. On the other hand, when the discontinuity width exceeds one bit, a repeat code, a code repeated multiple times, occurs.

In the input/output characteristics of the pipelined A/D converter, the DNL produces a discontinuity point, while the INL causes the input/output characteristics to deviate from the ideal characteristics. The deviation from the ideal characteristics can be corrected later relatively easily, while the correction of the discontinuity point is relatively difficult. In addition, considering an application of the pipelined A/D converter to a digital still camera or the like, it is preferable that the input/output characteristics of the pipelined A/D converter be continuous.

## SUMMARY OF THE INVENTION

In view of the above problem, it is therefore an object of the present invention to provide a high-precision pipelined A/D converter, in which no code error occurs, by improving the DNL characteristic of the pipelined A/D converter.

In order to overcome the above problem, an inventive pipelined A/D converter includes a plurality of cascade-connected stages and a digital calculation section for sequentially shifting digital outputs of the respective stages and adding resultant shifted digital values together, and one or more of the stages are controllable stages, each of which includes: an A/D converter for converting an analog input to the controllable stage to digital form and outputting a first digital signal as the digital output; a D/A converter for converting a digital input to analog form; a selecting device for selecting, as the digital input to the D/A converter, either the first digital signal output from the A/D converter or a supplied second digital signal; and a summing amplifier circuit for adding the analog input and an analog output of the D/A converter together and amplifying a resultant value. The inventive pipelined A/D converter includes: an input selecting section for detennining whether or not a normal input signal is supplied as the analog input to the controllable stage; an error calculation section for calculating an error in an output of the digital calculation section caused by an error in an analog output of the controllable stage; a correction value generation section for generating a correction value for correcting the output of the digital calculation section, based on the error calculated by the error calculation section; and an output correction section for correcting the output of the digital calculation section based on the correction value generated by the correction value generation section. In a state in which the normal input signal is not supplied as the analog input to the controllable stage, the error calculation section calculates the error based on an output of the pipelined A/D converter produced when the second digital signal is supplied to the D/A converter in the controllable stage and based on an expected value for that output of the pipelined A/D converter.

In the inventive pipelined A/D converter, an analog input to a controllable stage and a digital input to the D/A converter in the controllable stage are each put in a certain state, and based on the output of the pipelined A/D converter produced in this state and an expected value thereof, the error calculation section calculates an error in the output of the digital calculation section occurring due to an error in the analog output of the controllable stage. Based on the calculated error, the correction value generation section generates a correction value, and based on this correction value, the output correction section corrects the output of the digital calculation section.

The correction value generation section preferably includes: error storage sections, which are provided corresponding to the controllable stages, and each of which stores the error calculated by the error calculation section while associating the error with the second digital signal supplied to the D/A converter in the corresponding controllable stage, and outputs one of stored errors that corresponds to the first digital signal; and an adder for summing the errors output from the respective error storage sections and outputting a resultant total value as the correction value.

Also, the summing amplifier circuit in at least one of the controllable stages preferably includes: an operational amplifier; first and second capacitors; and a set of switches for selecting, as a connection state for the first and second capacitors, either a first connection state, in which the first capacitor is used for feedback of the operational amplifier and the second capacitor is used for output sampling of the D/A converter, or a second connection state that is opposite to the first connection state; and the pipelined A/D converter preferably includes a control section for controlling the set of switches in such a manner that either of the first and second capacitors that has a larger capacity value is used for feedback of the operational amplifier.

An inventive method is a method for correcting an output of a pipelined A/D converter which includes a plurality of cascade-connected stages and a digital calculation section for sequentially shifting digital outputs of the respective stages and adding resultant shifted digital values together, and in which at least one of the stages is a controllable stage that includes: an A/D converter for converting an analog input to the controllable stage to digital form and outputting a first digital signal as the digital output; a D/A converter for converting a digital input to analog form; a selecting device for selecting, as the digital input to the D/A converter, either the first digital signal output from the A/D converter or a supplied second digital signal; and a summing amplifier circuit for adding the analog input and an analog output of the D/A converter together and amplifying a resultant value. The inventive method includes: a first input selecting step of selecting the second digital signal as the digital input to the D/A converter in the controllable stage, in a state in which a normal input signal is not supplied as the analog input to the controllable stage; an error calculation step of calculating an error in an output of the digital calculation section caused by an error in an analog output of the controllable stage, based on an output of the pipelined A/D converter and an expected value thereof, after the first input selecting step has been performed; a correction value generation step of generating a correction value for correcting the output of the digital calculation section, based on the error calculated in the error calculation step; a second input selecting step of selecting the normal input signal as the analog input to the controllable stage, and selecting the first digital signal as the digital input to the D/A converter in the controllable stage; and an output correction step of correcting the output of the digital calculation section based on the correction value generated in the correction value generation step, after the second input selecting step has been performed.

According to the inventive method, an analog input to a controllable stage and a digital input to the D/A converter in the controllable stage are each put in a certain state, and based on the output of the pipelined A/D converter produced in this state and an expected value thereof, an error in the output of the digital calculation section occurring due to an error in the analog output of the controllable stage is calculated. Based on the calculated error, a correction value is generated, and based on the correction value, the output of the digital calculation section is corrected.

Preferably, the pipelined A/D converter includes a plurality of said controllable stages; and in the method, with the output of the digital calculation section being corrected based on the already generated correction value, the error is calculated sequentially for each of the controllable stages in the order of position starting from the last controllable stage.

As described above, according to the present invention, the DNL characteristic of the pipelined A/D converter is improved. Moreover, in the pipelined A/D converter of the present invention, the output correction is performed basically by summing operation, allowing the pipelined A/D converter to have a relatively simple circuit configuration, which is also relatively small in size.

## BRIEF DESCRIPTION OF THE DRAWINGS

FIG. **1** illustrates the configuration of a pipelined A/D converter according to a first embodiment of the present invention.
FIG. **2** illustrates the internal configuration of a controllable stage.
FIG. **3** illustrates the internal configuration of a correction value generation section.
FIG. **4** is a flow chart indicating a method for correcting the output of the pipelined A/D converter of the present invention.
FIG. **5** illustrates a (partial) circuit configuration of a controllable stage according to a second embodiment of the present invention.
FIG. **6** illustrates the circuit configuration of a controllable stage according to a third embodiment of the present invention.
FIG. **7** illustrates the configuration of a conventional pipelined A/D converter.
FIG. **8** illustrates the circuit configuration of a conventional 1.5-bit stage.
FIG. **9** is a graph indicating the analog input/output characteristics of the conventional 1.5-bit stage.

## DESCRIPTION OF THE PREFERRED EMBODIMENTS

Hereinafter, preferred embodiments of the present invention will be described with reference to the accompanying drawings.

(First embodiment)

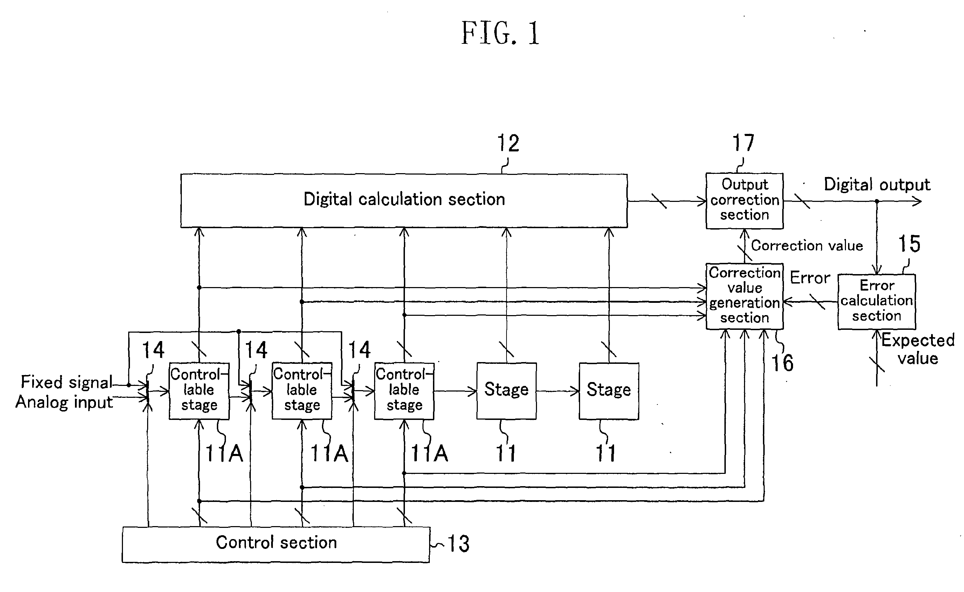

FIG 1 illustrates the configuration of a pipelined A/D converter according to a first embodiment of the present invention. The pipelined A/D converter of this embodiment includes a plurality of cascade-connected 1.5-bit stages **11** and 1.5-bit controllable stages **11A;** a digital calculation section **12;** a control section **13;** input selecting sections **14;** an error calculation section **15;** a correction value generation section **16;** and an output correction section **17.** Of these members, the configurations of the stages **11** and digital calculation section **12** are similar to those in the conventional converter, and the descriptions thereof will be thus omitted herein. Hereinafter, the other members will be described in detail. It should be noted that the respective numbers of controllable stages **11A** and stages **11** shown in FIG. **1** are given for the convenience of description, and the present invention is thus not limited to the illustrated configuration.

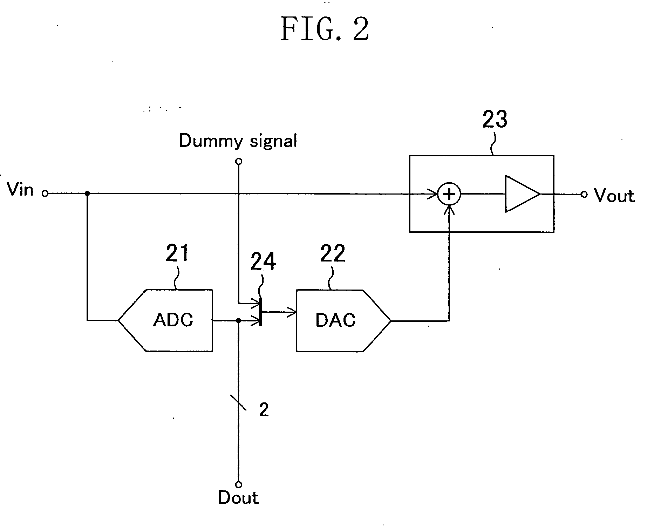

FIG. **2** illustrates the internal configuration of a controllable stage **11A.** An A/D converter **21** converts an analog signal **Vin** to digital form, thereby generating a digital signal **Dout.** A D/A converter **22** converts an input signal to analog form. A summing amplifier circuit **23** adds the analog signal **Vin** and the output of the D/A converter **22** together and doubles the resultant value for amplification, so as to output an analog signal **Vout**. A selecting device **24** selects, as a digital input to the D/A converter **22,** either the digital signal **Dout** (i.e., a first digital signal) output from the A/D converter **21** or a supplied dummy signal (i.e., a second digital signal). The dummy signal is a signal imitating a value the digital signal **Dout** can take.

Referring back to FIG. **1,** the control section **13** controls operation of each input selecting section **14** and operation of the selecting device **24** in each controllable stage **11A.** The control section **13** also supplies the dummy signal to each controllable stage **11A.**

The input selecting sections **14** are provided corresponding to the controllable stages **11A,** and select, under the control of the control section **13,** which signal is input to the corresponding controllable stage **11A.** Specifically, each input selecting section **14** selects either a normal input signal or a fixed signal. In this embodiment, for the initial controllable stage **11A,** the normal input signal is an analog input to the pipelined A/D converter, while for the second and successive controllable stages **11A,** the normal input signal is the analog output from the controllable stage **11A** prior to that stage. On the other hand, the fixed signal is an analog signal having a given size.

The fixed signal is preferably an analog signal at a zero level. This is because when the level of an analog input is zero, an error in the level of the analog output, caused by an error in the gain of the summing amplifier circuit **23** in the controllable stage **11A,** becomes a minimum, as shown in FIG. **9.** Instead of selecting the fixed signal, the analog input to the corresponding controllable stage **11A** may be blocked.

The error calculation section **15** calculates an error in the output of the digital calculation section **12** caused by an error in the analog output of each controllable stage **11A,** based on the digital output of the output correction section **17** and an expected value thereof. More specifically, the error calculation is performed as follows. A dummy signal is supplied to the D/A converter **22** in a controllable stage **11A** whose error is to be calculated (which will be hereinafter referred to as an "object stage"), with the fixed signal being selected as the analog input to the object stage by the input selecting section **14** or with the analog input being blocked. By doing this, the analog output of the object stage is not affected by errors in the analog outputs of the preceding controllable stages **11A** and depends only on the supplied dummy signal. In this manner, in a state in which the normal input signal is not supplied as the analog input to the object stage, the dummy signal is supplied to the D/A converter **22** in the object stage, and a difference between the output of the output correction section **17** produced in this situation and an expected value thereof is calculated. This difference may be considered as an error in the output of the digital calculation section **12** caused by the error in the analog output of the object stage.

The correction value generation section **16** generates a correction value for correcting the output of the digital calculation section **12,** based on the error calculated by the error calculation section **15.** The correction value generation section **16** then stores the generated correction value, and selects and outputs an appropriate one of the stored correction values to the output correction section **17** according to the digital output of each controllable stage **11A.** That is, the correction value generation section **16** outputs the optimal correction value according to the operating state of the D/A converter **22** in each controllable stage **11A** (see FIG. 2). In other words, the correction value generation section **16** operates as a memory circuit for outputting a value indicated by an address formed by the digital output of each controllable stage **11A,** i.e., the correction value, or operates as a look-up table.

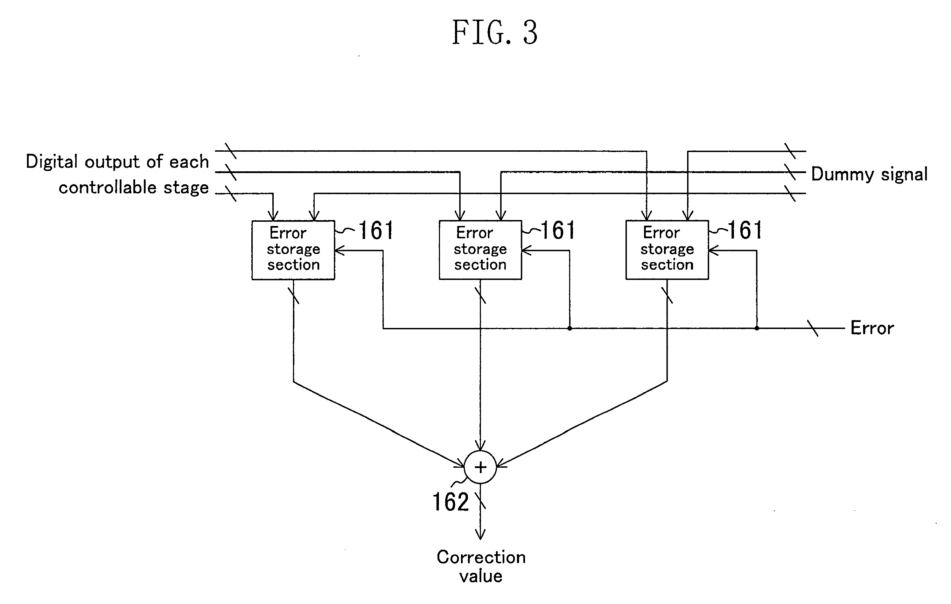

The correction value generation section **16** is preferably configured as follows. FIG. **3** illustrates the internal configuration of the correction value generation section **16.** Error storage sections **161,** which are provided corresponding to the controllable stages **11A,** each store an error in the output of the digital calculation section **12** caused by an error in the analog output of the corresponding controllable stage **11A.** More specifically, when storing the error calculated by the error calculation section **15,** each error storage section **161** associates the error with the dummy signal that corresponds to the calculation of that error. Each error storage section **161** also outputs one of the stored errors that corresponds to the digital output of the corresponding controllable stage **11A.** An adder **162** then sums the errors output from the respective error storage sections **161** and outputs the correction value for correcting the output of the digital calculation section **12.**

Referring back to FIG. **1,** the output correction section **17** corrects the output of the digital calculation section **12** based on the correction value generated by the correction value generation section **16.** Specifically, the output correction section **17** adds the correction value received from the correction value generation section **16** to the output of the digital calculation section **12.**

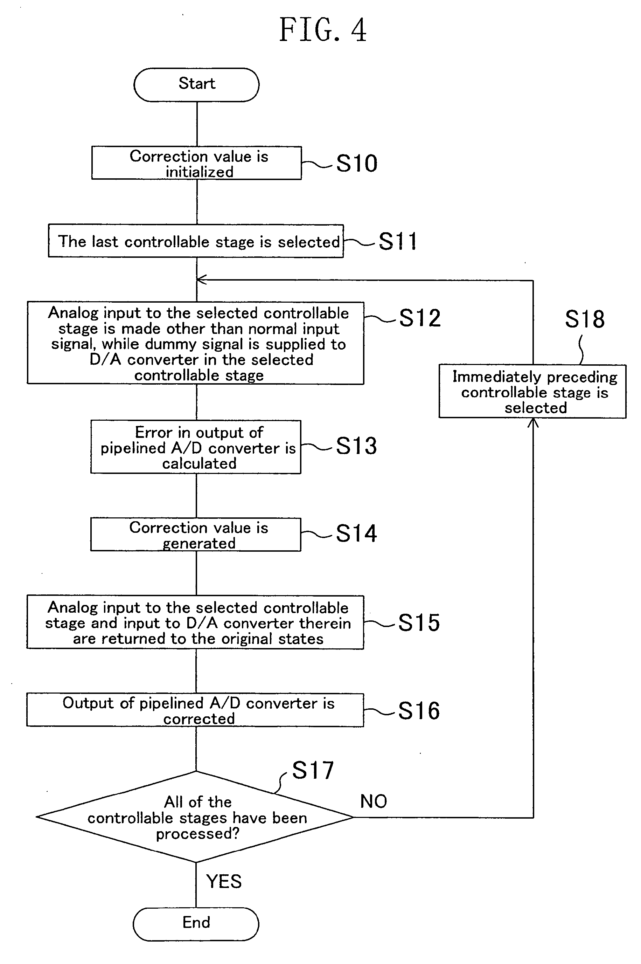

Next, the method for correcting the output of the pipelined A/D converter according to the present invention will be described with reference to a flow chart shown in FIG **4.** First, a correction value stored in the correction value generation section **16** is initialized (S10), and the last controllable stage **11A** in the pipelined A/D converter is selected as an object stage (S11). The analog input to the selected controllable stage **11A** is made other than the normal input signal, while a dummy signal is selected as the input to the D/A converter **22** in the selected controllable stage **11A** (S12: a first input selecting step). Subsequently, an error in the output of the digital calculation section **12** caused by an error in the analog output of the selected controllable stage is calculated (S13: an error calculation step), and based on the calculated error, a correction value for correcting the output of the digital calculation section **12** is generated (S14: a correction value generation step). Then, the normal input signal is selected as the analog input to the selected controllable stage **11A,** while the digital output of the A/D converter **21** is selected as the input to the D/A converter **22** in the selected controllable stage **11A** (S15: a second input selecting step), and the output of the digital calculation section **12** is corrected based on the correction value generated in Step **S14** (S16: an output correction step). Thereafter, it is determined whether or not all of the controllable stages **11A** have been processed (S17), and if all of the controllable stages **11A** have been processed, the correction of the output of the pipelined A/D converter is ended. If there remains an unprocessed controllable stage **11A,** the immediately preceding controllable stage **11A** is selected as an object stage (S18), and the procedure returns to Step **S12.** In this way, while the output of the digital calculation section **12** is corrected based on the already generated correction value, the correction value with respect to the preceding controllable stage is produced.

As described above, in this embodiment, the correction of the output of the pipelined A/D converter is performed basically by the summing operation of the correction values, which allows the pipelined A/D converter to have a relatively simple circuit configuration. Also, the correction value with respect to each controllable stage is generated in the state in which the errors with respect to the stages successive to that controllable stage have been eliminated. Therefore, the error that is specific to that controllable stage is calculated, permitting the generated correction value to be more precise. The pipelined A/D converter is thus capable correcting its output more accurately, while having a relatively small-sized circuit.

Moreover, not only the desirable correction value generation section **16** mentioned above is configured easily, but the configuration thereof can be changed very easily; if the number of controllable stages is increased, the necessary change is only the addition of the error storage sections **161.**

(Second embodiment)

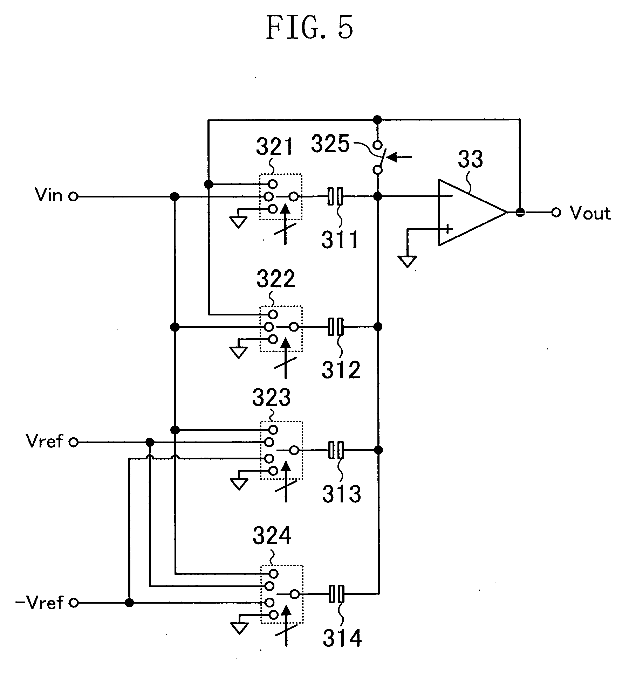

In the controllable stage shown in FIG **2,** the D/A converter **22** and the summing amplifier circuit **23** can be easily realized as an analog operational circuit by using a switched capacitor circuit. FIG **5** illustrates the configuration of a part (an analog operational circuit) of a controllable stage according to a second embodiment of the present invention. The analog operational circuit shown in FIG. **5** includes capacitors **311, 312, 313,** and **314,** switches **321, 322, 323, 324,** and **325,** and an operational amplifier **33.**

Hereinafter, it will be described how the controllable stage of this embodiment operates. In the following descriptions, signals (voltages) and the terminals supplying those signals will be identified by the same reference numerals.

A switched capacitor circuit is typically controlled by two-phase clocks whose active regions are not superimposed on each other. During normal operation, first, the switches **321** through **324** operate in synchronization with a first control clock, the capacitors **311** through **314** are connected to an analog signal **Vin,** and the switch **325** turns on. In this situation, if all of the capacitors **311** through **314** have the same capacity value **C,** an electric charge, represented by CVin, is stored in each of the capacitors **311** through **314.** Next, the switches **321** and **322** operate in synchronization with a second control clock, the capacitors **311** and **312** are connected to the output terminal of the operational amplifier **33,** and the switch **325** turns off. That is, the capacitors **311** and **312** are used for feedback of the operational amplifier **33.** Also, the switches **323** and **324** operate in synchronization with the second control clock, and the capacitors **313** and **314** are connected to one of the terminals that supply the potentials Vref, GND (analog ground potential), and -Vref, respectively. The terminal to which the capacitors **313** and **314** are connected is determined by the output of the A/D converter **21** (see FIG. **2**). That is, the capacitors **313** and **314** are used for output sampling of the D/A converter **22** (see FIG. **2**).

Considering that the electric charge (-4CVin) that has been stored at the inverting input terminal of the operational amplifier **33** is conserved according to the law of conservation of charge, an analog signal **Vout** is calculated differently depending upon where the capacitors **313** and **314** are connected. Specifically, the calculations are performed as follows.

(1) In the case where the capacitors **313** and **314** are connected to Vref:

$$-2CVout - 2CVref = -4CVin$$

$$\therefore Vout = 2Vin - Vref$$

(2) In the case where the capacitors **313** and **314** are connected to GND:

$$-2CVout = -4CVin$$

$$\therefore \mathrm{Vout} = 2\mathrm{Vin}$$

(3) In the case where the capacitors **313** and **314** are connected to -Vref:

$$-2C\mathrm{Vout} + 2C\mathrm{Vref} = -4C\mathrm{Vin}$$

$$\therefore \mathrm{Vout} = 2\mathrm{Vin} + \mathrm{Vref}$$

From this, it is found that the controllable stage of this embodiment has the same input/output characteristics as those of a typical stage.

Next, operation performed when a correction value is generated will be described. When a correction value is generated, the capacitors **311** and **312** are connected to GND. In this embodiment, the switches **321** and **322** operate as the input selecting sections **14** shown in FIG **1**. On the other hand, if the capacitors **313** and **314** are simultaneously connected to either the terminal **Vref** or **-Vref,** the analog signal **Vout** has a level of -Vref or Vref, i.e., a maximum amplitude level, and is output to the next stage. Depending upon the analog input/output characteristics of that next stage, the analog output level may exceed the maximum range to cause the occurrence of repeat codes in the stages successive to that next stage, such that the correction values may not be generated correctly. In view of this, the capacitors **313** and **314** are connected to the terminal **Vref** or **-Vref** not simultaneously but in sequence. This makes the analog signal **Vout** have a level of Vref/2 or -Vref/2, thereby preventing the occurrence of repeat codes in the successive stages. The correction values thus generated in the two steps may be stored in the correction value generation section **16** shown in FIG. 1 or the like, and then added at a time to the output of the digital calculation section **12** when the output of the pipelined A/D converter is corrected.

As described above, in this embodiment, the correction values for correcting the output of the pipelined A/D converter are generated stably. Therefore, the pipelined A/D converter is capable of correcting its output more precisely.

(Third embodiment)

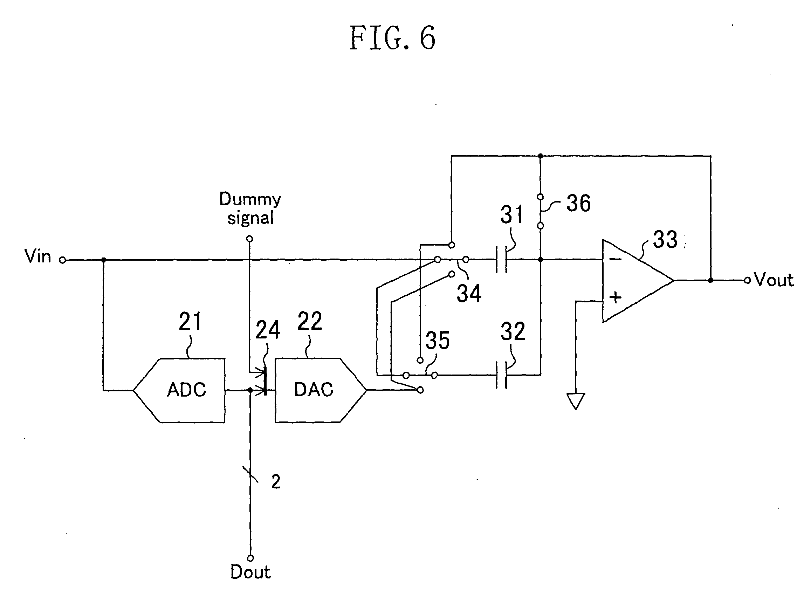

FIG. 6 illustrates the circuit configuration of a controllable stage according to a third embodiment of the present invention. The controllable stage of this embodiment includes an A/D converter **21,** a D/A converter **22,** a selecting device **24,** capacitors **31** and **32,** an operational amplifier **33,** and switches **34, 35,** and **36.** The capacitors **31** and **32** are each connected at one end to the inverting input terminal of the operational amplifier **33.** The A/D converter **21,** the D/A converter **22,** and the selecting device **24** function as described above.

The switch **34,** controlled by the control section **13** shown in FIG **1,** switches among the input terminal of an analog signal **Vin,** the output terminal of the operational amplifier **33,** and the output terminal of the D/A converter **22,** so that the other end of the capacitor **31** is connected to one of these terminals. Similarly, the switch **35,** controlled by the control section **13,** switches among the input terminal of the analog signal **Vin,** the output terminal of the operational amplifier **33,** and the output terminal of the D/A converter **22,** so that the other end of the capacitor **32** is connected to one of these terminals. The switch **36,** controlled by the control section **13,** opens/closes the circuit between the inverting input terminal and the output terminal of the operational amplifier 33.

The switches **34, 35,** and **36** provide the following two connection states for the capacitors **31** and **32.** In the first connection state, the capacitor **31** is used for feedback of the operational amplifier **33** (such a capacitor will be hereinafter referred to as a "feedback capacitor"), while the capacitor **32** is used for output sampling of the D/A converter **22** (such a capacitor will be hereinafter referred to as a "sampling capacitor"). In the second connection state, the capacitor **31** is used as a sampling capacitor, while the capacitor **32** is used as a feedback capacitor. More specifically, in the first connection state, a state, in which the switch **36** is closed and the capacitors **31** and **32** are each connected at the other end to the input terminal of the analog signal **Vin,** and a state, in which the switch **36** is opened and the capacitors **31** and **32** are connected at the other end to the output terminal of the operational amplifier **33** and to the output terminal of the D/A converter **22,** respectively, are repeated alternately. On the other hand, in the second connection state, a state, in which the switch **36** is closed and the capacitors **31** and **32** are each connected at the other end to the input terminal of the analog signal **Vin,** and a state, in which the switch **36** is opened and the capacitors **31** and **32** are connected at the other end to the output terminal of the D/A converter **22** and to the output terminal of the operational amplifier **33,** respectively, are repeated alternately.

There is some difference in capacity value between the capacitors **31** and **32.** This difference causes an error in the gain with respect to the analog output of the controllable stage. In particular, when the sampling capacitor has a larger capacity value than the feedback capacitor, the level of the analog output of the controllable stage may exceed the maximum range. In view of this, the switches **34** and **35** are controlled in such a manner that the feedback capacitor has a larger capacity value than the sampling capacitor. The level of the analog output of the controllable stage thus does not exceed the maximum range. Therefore, a correction value with respect to the controllable stage of this embodiment is generated in a single step.

As described above, in this embodiment, the correction value for correcting the output of the pipelined A/D converter is produced stably. Moreover, the circuit configuration of the controllable stage of this embodiment is simpler than that described in the second embodiment, and the correction value generation process of this embodiment is also simpler than that of the second embodiment.

Since the level of the analog output of the controllable stage of this embodiment does not exceed the maximum level, a signal at a maximum amplitude level, instead of a signal at a zero level, may be provided as the analog input supplied to the controllable stage when the correction value is generated.

Although the embodiments of the present invention have been described in the foregoing, the present invention is not limited to pipelined A/D converters that include 1.5-bit stages. According to the present invention, the above-described effects are also achieved in pipelined A/D converters that include 2.5-bit or higher stages.

As described above, the inventive pipelined A/D converters, which are highly accurate and have excellent differential linearity, are applicable, e.g., as front end portions of digital still cameras or the like, and as A/D converters for software-defined radio used in portable cellular phones or the like.

**Claims**

1. A pipelined A/D converter, which includes a plurality of cascade-connected stages and a digital calculation section for sequentially shifting digital outputs of the respective stages and adding resultant shifted digital values together, and in which one or more of the stages are controllable stages, each of which includes:

   an A/D converter for converting an analog input to the controllable stage to digital form and outputting a first digital signal as the digital output;
   a D/A converter for converting a digital input to analog form;
   a selecting device for selecting, as the digital input to the D/A converter, either the first digital signal output from the A/D converter or a supplied second digital signal; and
   a summing amplifier circuit for adding the analog input and an analog output of the D/A converter together and amplifying a resultant value,
   the pipelined A/D converter comprising:

   an input selecting section for determining whether or not a normal input signal is supplied as the analog input to the controllable stage;
   an error calculation section for calculating an error in an output of the digital calculation section caused by an error in an analog output of the controllable stage;
   a correction value generation section for generating a correction value for correcting the output of the digital calculation section, based on the error calculated by the error calculation section; and
   an output correction section for correcting the output of the digital calculation section based on the correction value generated by the correction value generation section,

   wherein in a state in which the normal input signal is not supplied as the analog input to the controllable stage, the error calculation section calculates the error based on an output of the pipelined A/D converter produced when the second digital signal is supplied to the D/A converter in the controllable stage and based on an expected value for that output of the pipelined A/D converter.

2. The pipelined A/D converter of Claim 1, wherein the correction value generation section includes:

   error storage sections, which are provided corresponding to the controllable stages, and each of which stores the error calculated by the error calculation section while associating the error with the second digital signal supplied to the D/A converter in the corresponding controllable stage, and outputs one of stored errors that corresponds to the first digital signal; and

an adder for summing the errors output from the respective error storage sections and outputting a resultant total value as the correction value.

3. The pipelined A/D converter of Claim 1, wherein the summing amplifier circuit in at least one of the controllable stages includes:

an operational amplifier;

first and second capacitors; and

a set of switches for selecting, as a connection state for the first and second capacitors, either a first connection state, in which the first capacitor is used for feedback of the operational amplifier and the second capacitor is used for output sampling of the D/A converter, or a second connection state that is opposite to the first connection state; and

the pipelined A/D converter includes a control section for controlling the set of switches in such a manner that either of the first and second capacitors that has a larger capacity value is used for feedback of the operational amplifier.

4. A method for correcting an output of a pipelined A/D converter which includes a plurality of cascade-connected stages and a digital calculation section for sequentially shifting digital outputs of the respective stages and adding resultant shifted digital values together, and

in which at least one of the stages is a controllable stage that includes:

an A/D converter for converting an analog input to the controllable stage to digital form and outputting a first digital signal as the digital output;

a D/A converter for converting a digital input to analog form;

a selecting device for selecting, as the digital input to the D/A converter, either the first digital signal output from the A/D converter or a supplied second digital signal; and

a summing amplifier circuit for adding the analog input and an analog output of the D/A converter together and amplifying a resultant value,

the method comprising:

a first input selecting step of selecting the second digital signal as the digital input to the D/A converter in the controllable stage, in a state in which a normal input signal is not supplied as the analog input to the controllable stage;

an error calculation step of calculating an error in an output of the digital calculation section caused by an error in an analog output of the controllable stage, based on an output of the pipelined A/D converter and an expected value thereof, after the first input selecting step has been performed;

a correction value generation step of generating a correction value for correcting the output of the digital calculation section, based on the error calculated in the error calculation step;

a second input selecting step of selecting the normal input signal as the analog input to the controllable stage, and selecting the first digital signal as the digital input to the D/A converter in the controllable stage; and

an output correction step of correcting the output of the digital calculation section based on the correction value generated in the correction value generation step, after the second input selecting step has been performed.

5. The method of Claim 4, wherein the pipelined A/D converter includes a plurality of said controllable stages; and in the method, with the output of the digital calculation section being corrected based on the already generated correction value, the error is calculated sequentially for each of the controllable stages in the order of position starting from the last controllable stage.

# FIG. 1

EP 1 635 469 A2

# FIG. 2

# FIG. 3

EP 1 635 469 A2

Digital output of each
controllable stage

Dummy signal

| Error storage section ~161 | Error storage section ~161 | Error storage section ~161 |

Error

+ ~162

Correction value

# FIG. 4

Start

Correction value is initialized —S10

The last controllable stage is selected —S11

Analog input to the selected controllable stage is made other than normal input signal, while dummy signal is supplied to D/A converter in the selected controllable stage —S12

S18

Immediately preceding controllable stage is selected

Error in output of pipelined A/D converter is calculated —S13

Correction value is generated —S14

Analog input to the selected controllable stage and input to D/A converter therein are returned to the original states —S15

Output of pipelined A/D converter is corrected —S16

S17

All of the controllable stages have been processed?

NO

YES

End

# FIG. 5

# FIG. 6

FIG. 7

12

Digital calculation section → Digital output

Analog input → Stage → Stage → Stage → Stage → Stage

11    11    11    11    11

EP 1 635 469 A2

# FIG. 8
## PRIOR ART

# FIG. 9
PRIOR ART

EP 1 635 469 A2